(19) Europäisches Patentamt / European Patent Office / Office européen des brevets

(11) **EP 2 749 892 B1**

(12) **FASCICULE DE BREVET EUROPEEN**

(45) Date de publication et mention de la délivrance du brevet:
**15.08.2018 Bulletin 2018/33**

(21) Numéro de dépôt: **13198813.1**

(22) Date de dépôt: **20.12.2013**

(51) Int Cl.:
*G01R 29/10* *(2006.01)*     *H01Q 3/26* *(2006.01)*
*H01Q 21/20* *(2006.01)*     *H04B 17/00* *(2015.01)*
*H04B 17/12* *(2015.01)*     *H04B 17/21* *(2015.01)*
*H04B 17/318* *(2015.01)*

(54) **Procédé et système pour calibrer une antenne**

Verfahren und System zum Kalibrieren einer Antenne

Method and system for calibrating an antenna

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.12.2012 FR 1203617**

(43) Date de publication de la demande:
**02.07.2014 Bulletin 2014/27**

(73) Titulaire: **Thales**
**92400 Courbevoie (FR)**

(72) Inventeurs:
• **Poulain, Jean-Louis**
**49309 CHOLET (FR)**
• **Goubet, Antoine**
**49309 CHOLET (FR)**
• **Lestieux, Sébastien**
**49309 CHOLET (FR)**

(74) Mandataire: **Dudouit, Isabelle et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**WO-A1-2010/136409     JP-A- H05 302 947**

• **CHRISTOPHER M WRIGHT ET AL: "A MIMO ground station for unmanned aerial system telemetry and data links", SOUTHEASTCON, 2011 PROCEEDINGS OF IEEE, IEEE, 17 mars 2011 (2011-03-17), pages 191-195, XP031943051, DOI: 10.1109/SECON.2011.5752931 ISBN: 978-1-61284-739-9**

**Description**

L'invention concerne un procédé et un système permettant de réaliser un calibrage d'une antenne d'infrastructure, c'est-à-dire soit une antenne fixe positionnée en haut d'un pylône, d'un mât ou en haut d'un immeuble, soit une antenne positionnée dans la mature d'un navire.

Le procédé est notamment utilisé pour le calibrage d'antenne installée sur des infrastructures et dont les dimensions sont assez importantes et/ou qui ne peuvent être déplacées facilement.

Dans la suite de la description, lorsque l'on parle de calibration d'antennes, on vise la détermination des écarts réalisés sur des mesures angulaires faites par l'antenne dus à des imperfections des composants de l'antenne. Cela concerne tout type d'antenne effectuant des relevés d'angles par le principe de l'interférométrie (relevé de la différence de chemin parcouru par l'onde incidente entre deux points de l'antenne). On citera par exemple les antennes de goniométrie travaillant avec ce principe d'interférométrie.

La calibration prend en compte les éléments antennaires que sont les dipôles, les éléments électroniques de réception ainsi que les câbles de descente d'antenne.

Dans le cas d'antennes de stations fixes, dites antennes d'infrastructure, une fois que celles-ci sont installées à demeure sur une hauteur ou un pylône, le problème se pose de maintenir à jour une table de calibration. En effet, une fois installées, ces antennes ne sont généralement pas recontrôlées. Dans le cas d'une panne majeure, on démonte l'antenne et on réexpédie cette antenne dans un lieu comportant une installation qui permet de recalibrer l'antenne, ses composants antennaires ainsi que les éléments de la chaîne de réception, les câbles de liaison.

La fonction principale de la calibration est d'étalonner, par une mesure directe ou indirecte, la réponse du réseau d'antennes ou de dipôles d'une antenne en fonction de l'angle et de la fréquence. Dans les dispositifs électroniques la mesure comporte, en général, la réponse de l'antenne proprement dite et la réponse des chaînes de réception caractérisant les imperfections des étages des voies de réception. Le principe de base, lorsque l'on emploie une référence externe pour faire la mesure, consiste à mesurer pour un nombre adéquat de valeurs de fréquences f et de valeurs de directions $\theta$, la réponse globale de l'antenne.

La calibration d'une antenne de goniométrie, ou autre, consiste donc à effectuer un relevé d'un signal émis par une source connue : fréquence, niveau du signal, direction d'émission. Le principe connu selon l'art antérieur, dans le cas d'antennes d'infrastructure difficiles à déplacer, est de faire tourner l'antenne à calibrer, la source étant fixe, afin d'effectuer un relevé de signaux à 360° et de déterminer les perbrmances en réception de l'antenne. Les données mesurées (niveau du signal, valeur de l'angle) sont ensuite comparées à des données de référence. Le relevé obtenu comporte des écarts avec la réalité étalonnée. Ces écarts peuvent être dus aux imperfections de l'assemblage mécanique de l'antenne (jeux tolérances de cotes, etc.), à des écarts de tolérance des composants passifs ou actifs de l'électronique, à des écarts de précision sur la longueur des câbles, ou des trois causes à la fois. Ces écarts sont inversés et entrés dans une table de calibration qu'utilise le goniomètre pour donner la direction relevée avec le niveau de précision voulu. Cette table de calibration est établie à partir d'une campagne de mesures de relevés effectuée sur un site particulier, radio-électriquement propre et non encombré de constructions ou de lignes électriques haute tension. Une fois mémorisée, cette table va être utilisée pour vérifier que le goniomètre atteint effectivement ses performances attendues en termes de précision et de qualité de mesure. La recette usine peut alors être effectuée. Cette table reste dans la mémoire du goniomètre, même lorsque l'antenne est déployée sur son site définitif avec un environnement très différent de la base de calibration. Or, dans le temps, la table de calibration peut ne plus être représentative du fait de perturbations introduites par l'apparition de nouvelles constructions proches du site, générant des échos, ou encore par le vieillissement progressif de l'antenne, les jeux mécaniques pouvant s'amplifier sous l'effet d'intempéries ou autres, les câbles ou les composants peuvent vieillir et s'user.

La question se pose sur la conservation dans le temps de la validité de la table de calibration et donc de la précision de mesure du système. Il faudrait donc être en mesure de recalibrer périodiquement le système. Or ceci nécessite actuellement un retour usine, un démontage de l'antenne, son transport, son installation sur un site équipé de moyens spécifiques permettant de recalibrer l'antenne, ainsi qu'une immobilisation de l'antenne goniomètre pendant plusieurs mois, qui se révèlent être des opérations coûteuses.

La figue 1 schématise une technique de calibration selon l'art antérieur mise en oeuvre pour un réseau antennaire circulaire 1 comprenant 5 éléments antennaires. La technique prend en compte les caractéristiques physiques du réseau de capteurs. La calibration avec un signal pilote Sp consiste à mesurer la réponse R du réseau de capteurs en fonction de l'angle d'incidence $\theta i$ d'une source 2 et en faisant tourner l'antenne 1 autour de la source 2 qui reste fixe. Une table de calibration avec un nombre fini de réponses est construite. Ces réponses sont traitées afin de produire une expression analytique de la réponse du réseau.

Il existe donc un besoin réel de disposer d'un procédé et d'un système de calibrage qui permettent de ne pas déplacer l'antenne pour la calibrer ou vérifier sa calibration, le recalibrage se faisant sur le site.

Par ailleurs, la calibration actuelle est réalisée avec des antennes situées à une hauteur fixe : on calibre donc les antennes, pour un signal reçu, dans une élévation donnée. Certaines applications, outre la détermination de l'azimut du signal reçu, détermine un angle en élévation du signal reçu. Dès lors, la calibration d'une antenne pour divers angles d'élévations serait un plus pour améliorer la précision de la détermination de l'angle d'élévation.

Le document JP H05 302947 divulgue un procédé pour calibrer une antenne fixe, comportant l'utilisation d'un aéronef.

L'invention concerne un procédé pour calibrer une antenne fixe comportant plusieurs dipôles caractérisé en ce qu'il comporte au moins les étapes suivantes

- l'utilisation d'un aéronef équipé d'une antenne directive large bande, ledit aéronef effectuant une rotation autour de ladite antenne fixe à calibrer, l'émission d'un signal à partir de l'antenne de l'aéronef dans une plage de fréquences $[F_1, F_2]$ pour lesquelles on cherche à calibrer ladite antenne,
- la mesure du niveau Nsa, Nsb, Nsc, Nsd, Nse de signal reçu par un dipôle et la mesure des différences de phase entre chaque dipôle de l'antenne à calibrer, pour chaque fréquence Fr de la plage de fréquences sélectionnée, au cours d'une rotation de T ° de l'aéronef autour de l'antenne à calibrer,
- la détermination d'une note de qualité du signal reçu par comparaison d'un niveau de signal mesuré à un niveau de signal attendu pour un angle d'émission donné,
- la mémorisation des valeurs des écarts entre l'angle incident mesuré et l'angle incident théorique pour une valeur de fréquence Fr, dans une table de calibration.

L'aéronef est, par exemple, un drone comprenant une composante sol et une composante embarquée qu'il comporte au moins les étapes suivantes :

3.a) le drone se positionne à un azimut initial situé sur un cercle de rayon R déterminé à partir des coordonnées de l'antenne à calibrer, et transmet les informations de son positionnement et un signal « prêt » à émettre à la composante sol du drone,

3.b) la composante sol du drone configure la chaîne de réception du de l'antenne à calibrer pour une détection dans une fréquence Fr voulue et transmet un top d'émission au drone,

3.c) l'antenne du drone émet à la fréquence attendue Fr, et communique à la composante sol sa position X datée et la fréquence émise Fe,

3.d) les dipôles de l'antenne à calibrer reçoivent l'onde émise, et la chaîne de réception de l'antenne mesure la valeur de l'amplitude du signal reçu pour chacun des dipôles, ainsi que les différences de phase entre chaque dipôle,

3.e) le drone suit toujours la circonférence autour de l'antenne, sans marquer d'arrêt, et transmet tous les x degrés parcourus, une information de positionnement datée et la fréquence émise, et les valeurs mesurées en 3d),

3.f) en fin de circonférence, le drone émet une information de prêt à émettre et reboucle à l'étape 3.b) en incrémentant la valeur de fréquence de Δf puis exécute les étapes 3.c) 3.d) et 3.e),

3.g) le procédé est terminé lorsque tous les azimuts ont tous été balayés avec la bande de fréquence complète.

D'autres caractéristiques et avantages de la présente invention apparaîtront mieux à la lecture de la description qui suit donnée à titre illustratif et nullement limitatif, annexée des figures qui représentent :

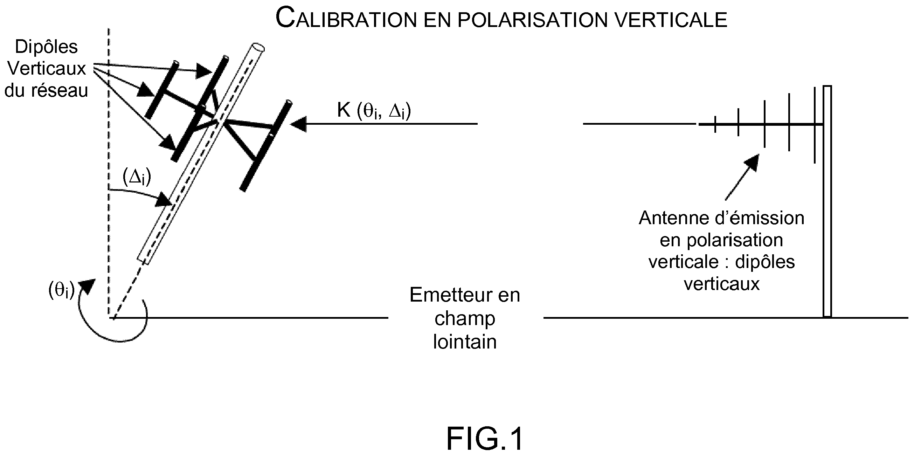

- La figure 1, un schéma illustrant une technique de calibration,
- La figure 2, une représentation d'un système selon l'invention,

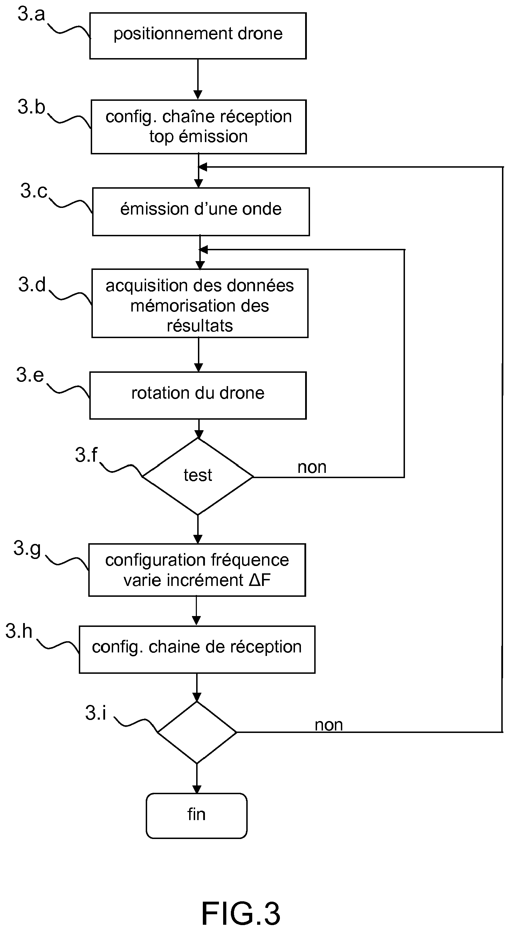

- La figure 3, l'enchainement et la succession des étapes exécutées par le procédé selon un mode possible de fonctionnement de l'invention, dans lequel le drone effectue autant de révolutions que de fréquences à calibrer.
- La figure 4, l'enchainement et la succession des étapes exécutées par le procédé selon un autre mode de fonctionnement possible de l'invention, dans lequel le drone effectue une seule révolution autour de l'antenne,
- La figure 5, un exemple de schéma de synchronisation.

L'idée mise en oeuvre par la présente invention repose notamment sur l'utilisation d'un équipement mobile ayant la capacité d'effectuer une ou plusieurs rotations autour de l'antenne à recalibrer, et pourvu de moyens d'émission de radiofréquences.

L'exemple donné fait référence à un drone qui va effectuer une rotation autour de l'antenne à calibrer ou à recalibrer, l'antenne étant fixe et située dans une position donnée. L'antenne à calibrer est fixée, par exemple, en haut d'un pylône ou d'un bâtiment, ou dans la mature d'un navire, par exemple et sa position GPS et son altitude sont connues. A partir des coordonnées géographiques $X_A$ de l'antenne on déduira les coordonnées géographiques du drone $X_D$. L'antenne et le drone peuvent être repérés dans un repère géodésique, en utilisant la longitude, latitude, l'azimut ou encore dans tout autre repère.

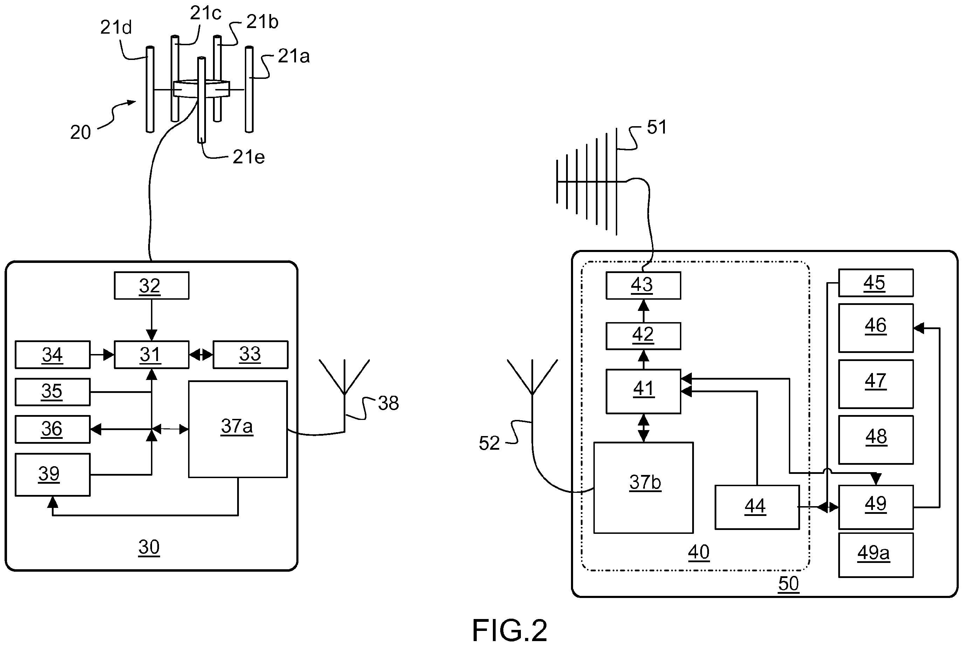

La figure 2 schématise une antenne 20 à calibrer et un système drone 50 comportant une composante sol du système 30 et une composante embarquée 40 compsée du drone, de sa charge utile et de son système de transmission détaillés ci-après. Le drone assure le pilotage et la navigation de façon automatique en fonctionnement normal. L'antenne 20 est reliée à la composante sol du système 30 via un récepteur 32 et des moyens de communication.

L'antenne 20 à calibrer est par exemple cons-

tituée de 5 bras $20_1$, $20_2$, $20_3$, $20_4$, $20_5$, disposés selon 360°, les bras se rejoignant par une extrémité au centre de l'antenne. Chaque bras est équipé d'un dipôle $21_a$, $21_b$, $21_c$, $21_d$, $21_e$.

La composante sol 30 comporte un processeur 31.Les paramètres de calibrage de l'antenne sont mémorisés, par exemple, dans une première table initiale de calibration 35. Un logiciel spécifique de calibration 34 exécuté sur le processeur 31 permettant de réaliser une calibration de l'antenne fait une observation pour une fréquence de référence donnée. Les valeurs mesurées du niveau de signal reçu sur chacun des dipôles et les valeurs d'écart de phase entre dipôles pour la valeur de fréquence donnée sont mémorisés dans la table de mesures 36. Les différences de phase entre dipôles permettent de calculer l'angle incident de l'onde reçu par les dipôles qui est immédiatement calculé et mémorisé.

Cette nouvelle table de mesures 36 deviendra la nouvelle table de calibration après validation par un opérateur au travers d'une Interface Homme Machine 33. Un logiciel de calibration 34 est embarqué au niveau de la composante sol du système. La composante sol comporte aussi une interface 37a de communication bidirectionnelle du drone (interface de télémétrie) consistant, par exemple, en un émetteur/récepteur et une antenne 38 de communication avec le drone 50. Cette interface bidirectionnelle communique vers le drone 50 les commandes propres au process de calibration et renseigne une mémoire 39 des informations communiquées par le drone 50. Ces informations sont par exemple des informations de positionnement, les coordonnées du drone, qui seront ensuite exploitées par le processeur 31 pour établir la valeur d'angle théorique.

La composante système embarquée 40 comprend notamment différents éléments connus de l'Homme du métier. La composante système embarquée 40 comporte une chaîne émission composée d'un émetteur 42, d'un amplificateur 43 et d'une antenne directive large bande 51. Cette chaîne d'émission est capable de balayer la plage de fréquences nécessaire pour calibrer l'antenne 20. Pour la mise en oeuvre du procédé l'antenne directive 51 du drone est adaptée à la sous-bande de fréquence à calibrer. Elle rayonne une onde de fréquence $F_1$, par exemple, dans une direction $\theta_1$ mesurée par rapport à un repère fixe de l'antenne. Ce repère peut être un dipôle choisi comme référence.

La composante embarquée du système comporte aussi, par exemple, un processeur 41, des capteurs de vol 45 mesurant les paramètres du vol, un calculateur 49 dédié au pilotage et à la navigation et d'où sont émis les ordres de pilotage, une mémoire 49a contenant la programmation du vol et des actionneurs 46 agissant sur les commandes de vol. Pour la navigation et le contrôle, la composante embarquée du système comprend un système de positionnement 44 ayant pour fonction de donner à tout instant les coordonnées précises du drone. Le système de navigation est par exemple une centrale inertielle connue de l'Homme du métier, éventuellement couplée à un GPS différentiel (Differential Global Positioning System). La précision de ce système de positionnement donne la précision des angles théoriques en azimut et en élévation. Si, par exemple, le système donne une précision de +/-50cm pour un drone volant à 500m de l'antenne à calibrer, l'angle théorique en azimut est alors connu avec une précision égale à +/- 0,06°. Le drone dispose d'une interface de communication 37b bidirectionnelle (interface de télémétrie) et d'une antenne 52 de comunication avec le sol permettant la transmission de données entre le drone 50 et la composante sol du système 30 et qui achemine à la fois les ordres venant du sol, et les informations de positionnement envoyées par le drone.

Suite à l'émission d'une onde à partir de l'antenne 51 du drone 50, le signal reçu par chaque dipôle $21_a$, $21_b$, $21_c$, $21_d$, $21_e$ de l'antenne à calibrer est distribué au récepteur 32 de la composante sol du système 30. Chaque capteur ou dipôle $21_a$, $21_b$, $21_c$, $21_d$, $21_e$ de l'antenne à calibrer 20 va recevoir le front d'onde émis par l'antenne directive du drone avec un déphasage $\varphi ip$ où i est l'indice du dipôle qui reçoit l'onde et p un indice correspondant à un autre dipôle de l'antenne du drone.

Les paramètres de calibrage de l'antenne sont mémorisés, par exemple, dans une première table initiale de calibration 34. Le logiciel spécifique de calibration 35 exécuté sur le processeur 31 permettant de réaliser une calibration de l'antenne fait une observation pour chacun des dipôles $21_a$, $21_b$, $21_c$, $21_d$, $21_e$, pour une fréquence de référence Fr donnée. Les valeurs mesurées du niveau de signal Nsa, Nsb, Nsc, Nsd, Nse, reçu sur chacun des dipôles $21_a$, $21_b$, $21_c$, $21_d$, $21_e$ et les valeurs $\varphi_{a,b}$, $\varphi_{b,c}$, $\varphi_{b,d}$, $\varphi_{d,e}$, $\varphi_{e,a}$ d'écart de phase entre dipôles pour la valeur de fréquence donnée Fr sont mémorisées dans la table de mesures 36. Les différences de phase entre dipôles permettent de calculer l'angle incident $\theta i$ de l'onde reçue par chaque dipôle qui est immédiatement calculé et mémorisé dans la table de mesures 36 . L'angle incident théorique est bâti à partir de la position Cd du drone 50 communiqué en temps réel. La table des valeurs de l'écart entre l'angle incident théorique et l'angle incident mesuré devient la nouvelle table de calibration .

Le logiciel de calibration 34 s'attend à un niveau de signal reçu donné, qui est en fonction de l'angle et de la fréquence utilisée pour les mesures. Si le niveau Ns de signal est acceptable, la mesure de l'angle incident $\theta i$ est attribuée à un dipôle et elle est mémorisée dans la nouvelle table de calibration.

Le niveau de signal reçu sur les dipôles de l'antenne peut être perturbé en fonction des émetteurs locaux. Par exemple, en bande FM, les émetteurs locaux vont additionner leurs signaux à ceux émis par le drone. Le logiciel de calibration est adapté pour corriger ce problème, en soustrayant, par exemple, de la table de fréquence à calibrer les fréquences des émetteurs connus et perturbateurs.

Les informations du système de positionnement peuvent être utilisées notamment pour soit maintenir à une position relativement stable le drone, soit communiquer à la composante sol du système la position du drone au moment du top émission. La stabilité du drone est importante pour optimiser la réception. Le drone 50 porte, par exemple, une antenne directive large bande 51 à polarisation verticale. Or, le récepteur 32 est susceptible de recevoir un signal atténué si sa propre polarisation n'est pas correctement adaptée à celle du signal qu'il doit capter. L'antenne à calibrer 20 est fixe et attend une polarisation verticale du champ pour optimiser la réception. Dans cet exemple il est important que le faisceau émis présente une polarisation verticale. Des oscillations du drone vont faire baisser le niveau reçu par le récepteur 32.

Le drone sera positionné, suffisamment loin de l'antenne à calibrer, de sorte que, vu des dipôles de l'antenne, les ondes émises par l'antenne directive 51 du drone soient parallèles ou sensiblement parallèles. Cette approximation est vraie également pour la hauteur des brins. En pratique, par exemple 300m peuvent suffire. Cette distance correspond simplement à la distance où le lobe de l'antenne émission est constitué et homogène (en pratique égal à 10 x longueur d'onde de la fréquence de base). Il est nécessairement plus grand en basse fréquence (bas de la bande VHF) qu'en haute fréquence (haut de la bande UHF ou SHF): de ce fait on pourrait imaginer des distances variables pour le drone en fonction de la fréquence calibrée, ce qui n'est pas envisageable du fait de la diminution concomitante de la précision du positionnement du drone si la distance diminue. En fonction des caractéristiques du terrain, une distance de 500m entre l'antenne directive du drone et l'antenne à calibrer pourra être choisie.

Dans la description qui va suivre, deux exemples de calibration vont être décrits selon le type d'aéronef utilisé pour le drone.

Le calculateur de vol 49 fait rallier au drone 50 une position initiale de référence. La chaîne émission 42-43-51 est activée à une fréquence donnée. Cette chaîne est composé d'un émetteur 42 capable balayer une large plage de fréquence, un amplificateur 43 adapté à la plage de fréquence considérée et une antenne directionnelle large bande 51.

Dans les deux modes de fonctionnement et selon les possibilités offertes en terme de charge utile et d'adaptation des antennes aux fréquences à calibrer il peut être nécessaire de changer d'antenne d'émission 51, voire d'amplificateur 43 ou d'émetteur 42.

Selon un premier mode de réalistion, le drone effectue une révolution complète autour de l'antenne 20 en signalant à la composante sol au niveau du module 39 sa position datée tous les x degrés, par exemple tous les quatre degrés.

Une fois la révolution terminée, la fréquence est incrémentée sur l'émetteur 42, selon un pas de fréquence propre à la sous-bande d'antenne à calibrer sous test. Puis le drone 50 effectue une nouvelle révolution autour de l'antenne 20. Le drone effectue autant de tours d'antenne que de fréquences à calibrer.

Une fois la bande de fréquence de la sous-bande d'antenne balayée, on peut passer à la sous-bande supérieure (incrément du pas de fréquence différent).

Les étapes mises en oeuvre par le procédé sont alors les suivantes :

> 3.a) le drone se positionne à un azimut initial situé sur un cercle de rayon R (par exemple 500m) qui est déterminé à partir des coordonnées de l'antenne à calibrer. La chaine émission est configurée pour émettre à la fréquence initiale Fi de la bande de fréquence à balayer. La télémétrie du drone transmet les informations de positionnement du point initial du drone à la composante sol du système ainsi qu'une information avertissant qu'il est prêt à émettre, le drone commence à suivre une circonférence T autour de l'antenne à calibrer,
> 3.b) la composante sol du drone configure la chaîne de réception du goniomètre pour une détection dans une fréquence voulue Fc et transmet un top d'émission au drone, à l'aide de l'interface de communication du drone (télémétrie),
> 3.c) l'antenne directive du drone est dirigée en permanence vers l'antenne et émet à une fréquence attendue, et communique à la composante sol sa position X datée et la fréquence émise,
> 3.d) la réception des informations de positionnement datées du drone déclenche l'acquisition des données reçues sur la chaîne de réception de l'antenne. On mesure la valeur du niveau de signal reçu sur chacun des dipôles et les différences de phase entre chaque dipôle. Le processeur de de la composante sol détermine l'angle incident mesuré à partir de ces mesures ainsi que l'angle théorique à partir des informations de positionnement. L'écart angulaire est déterminé, une note de qualité est élaborée à partir du niveau reçu. L'ensemble des infromations est stocké en mémoire de mesures 36,
> 3.e) le drone suit toujours la circonférence autour de l'antenne, sans marquer d'arrêt, et transmet tous les quatre degrés parcourus, par exemple, l'information de sa position Xd datée et la fréquence émise,
> 3.f) le processeur de la composante sol va tester si le drone a parcouru la circonférence du cercle,
>
>> s'il n'a pas terminé, alors le procédé repart à l'étape 3d),
>> dans le cas contraire, le procédé passe à l'étape suivante 3g) le drone reconfigure la chaine d'émission avec un pas de fréquence déterminé, et avertit la composante sol par un top prêt à émettre, puis 3.h) sur réception du top prêt à émettre du drone, la chaine de réception de la composante sol est configurée avec le même pas de fréquence utilisé sur le drone. Un top émission est envoyé au drone,

3.i) le procédé teste si toutes les fréquences ont été balayées, si ce n'est pas le cas, alors le procédé retourne à l'étape 3c), sinon, le procédé est terminé tous les azimuts ont tous été balayés avec la bande de fréquence complète, généralement on fait varier l'azimut de 360°,

Après autant de tours parcourus que de fréquences à calibrer, le drone revient se poser à son point de décollage,

3.i) au niveau de la chaîne de réception de l'antenne à calibrer on dispose à la fin de ces étapes d'un tableau regroupant pour une valeur de fréquence donnée Fr, une valeur d'angle d'azimut donné, les valeurs d'amplitude ou niveaux des signaux reçus sur chacun des dipôles, les valeurs des angles de déphasage entre l'arrivée de l'onde sur le premier dipôle de référence et sur les autres dipôles. Cette nouvelle table de mesures 36 deviendra la nouvelle table de calibration après validation par un opérateur au travers d'une Interface Homme Machine 33.

Par exemple, pour une distance drone-antenne à calibrer de 500m, et un drone volant à 62,8km/h, le drone émet régulièrement toutes les deux secondes sa position et la fréquence émise. Dans ces conditions, une révolution dure 3mn, une calibration complète comprenant environ 300 mesures, la calibration complète est couverte en 15 heures (hors changement de charge utile selon la bande de fréquence sous test et hors ravitaillement du drone).

Un deuxième mode de mise en oeuvre consiste, par exemple, à pratiquer par points fixes. Le drone 50 se positionne à une position de référence, et fait balayer à l'émetteur 42 la bande de fréquence complète. Le drone 50 communique à la composante sol du système (module 39) en permanence la valeur de fréquence émise par son émetteur 42 et l'antenne 51, ainsi que sa position datée.

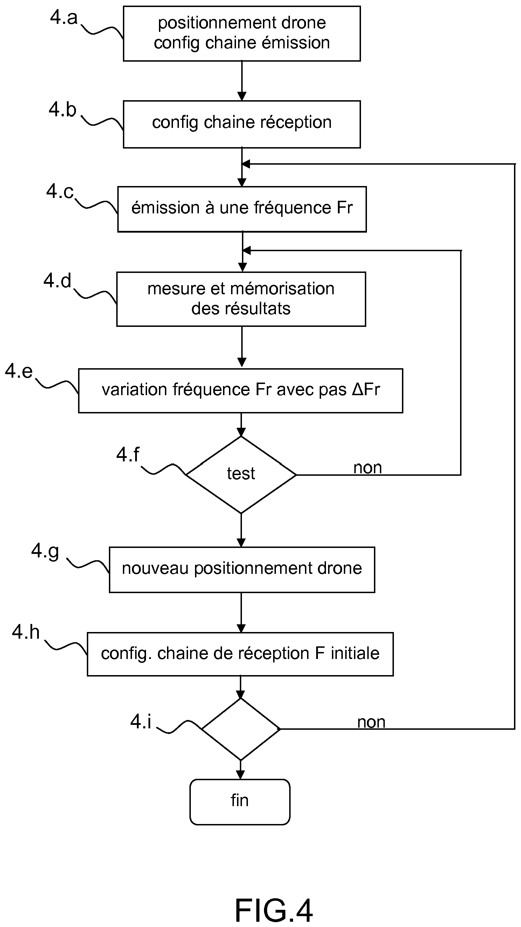

La figure 4 représente la succession des étapes mises en oeuvre par le procédé selon l'invention dans le cas d'un système tel que représenté à la figure 2:

4.a) le drone se positionne à un azimut initial situé sur un cercle de rayon R (par exemple 500m) qui est déterminé à partir des coordonnées de l'antenne à calibrer. La chaîne émission est configurée pour émettre à la fréquence initiale de la bande de fréquence à balayer. La télémétrie du drone transmet les informations de positionnement du point initial du drone à la composante sol du système ainsi qu'une information indiquqant qu'il est prêt à émettre. Le drone a donc averti l'antenne qu'il est prêt à émettre; le drone est en positoin stationnaire sur sa position initiale,

4.b) la composante sol configure la chaîne de réception du goniomètre pour une détection dans une fréquence voulue Fc et transmet un top d'émission au drone, à l'aide de l'interface de communication du drone (télémétrie),

4.c) l'antenne directive du drone émet à la fréquence attendue Fc, et communique à la composante sol sa position datée et la fréquence émise Fe,

4.d) la réception des informations de positionnement datées du drone déclenche l'acquisition des données reçues sur la chaîne de réception de la composante sol. les dipôles de l'antenne reçoivent l'onde émise, et la chaîne de réception de l'antenne va mesurer la valeur de l'amplitude du signal reçu sur chacun des dipôles, et les différences de phase entre chaque dipôle. Le processeur de la composante sol détermine l'angle théorique à partir des informations de positionnement. L'écart angulaire est déterminé. La note de qualité de la mesure est élaborée à partir du niveau de signal reçu. L'ensemble des informations est stocké en mémoire. Le drone resté sur sa position, le procédé vérifie si toutes les valeurs de fréquence de calibration ont été balayées,

Si non alors le procédé va reconfigurer la chaîne d'émission avec un pas de fréquence déterminé, et exécute l'étape 4c),

4.e) une fois les mesures effectuées pour la première fréquence, la composante sol du système transmet au drone un ordre de changement de fréquence, on passe à une fréquence $F_{i+1}=F_i+\Delta F$,

4.f) les étapes c), d) et e) sont réitérées jusqu'à ce que toute la bande de fréquence soit balayée,

4.g) lorsque la plage de fréquences correspondant à la bande d'émission est parcourue, la chaîne de réception transmet un ordre au drone lui demandant de se positionner dans un nouvel azimut A+ΔA, en suivant un cercle de rayon R autour de l'antenne à calibrer et les étapes 4.b) à 4.f) sont réitérées,

4.h) le procédé est terminé lorsque la bande de fréquence et les azimuts ont tous été balayés, généralement on fait varier l'azimut de 360°.

Pour un azimut donné, le système sol et embarqué doivent balayer la bande de fréquences complète, soit par exemple 300 fréquences. Le rythme des incréments de fréquence est limité par la durée nécessaire à la reconfiguration des chaînes émission sur le drone et de la chaîne de réception sur le récepteur. Le rythme maximum des échanges autorisant un changement de fréquence est par exemple de 250 milli-secondes. Dans ces conditions et par azimut, le process dure 1,15mn. Le calibrage s'effectuant avec un pas de 4° en azimut, la durée propre de calibrage est de 1h52mn30s. Il faut ajouter le temps mis par le drone pour passer d'un azimut à un autre espacé de 4° et se stabiliser. On prendra par exemple 2mn. Il faut donc ajouter un total 3h de repositionnement du drone. Soit un global d'environ 5h de vol,hors changement de charge utile selon la bande de fréquence sous test et hors ravitaillement du drone,

4.i) au niveau de la chaîne de réception de l'antenne à calibrer on dispose à la fin de ces étapes d'un tableau regroupant pour une valeur de fréquence donnée Fr, une valeur d'angle d'azimut donné, les valeurs d'amplitude ou niveaux des signaux reçus sur chacun des dipôles, les valeurs des angles de déphasage entre l'arrivée de l'onde sur le premier dipôle de référence et sur les autres capteurs.

Les différences de phase entre dipôles permettent de calculer l'angle incident de l'onde reçu par les dipôles. La valeur du niveau du signal reçu valide la mesure. Cette valeur est datée.

Le goniomètre calcule la valeur de l'angle théorique attendu à partir des positions enregistrées et datées, communiquées par le drone ainsi que de la position connue de l'antenne à calibrer. Cette valeur théorique est comparée à l'angle relevé. L'écart constitue un décalage que l'on va entrer dans la nouvelle table de calibration 36.

Le procédé et le système selon l'invention sont utilisés, par exemple, pour calibrer des antennes fonctionnant dans la plage de fréquences 20 MHz et 3 GHz et jusqu'à 6 GHz.

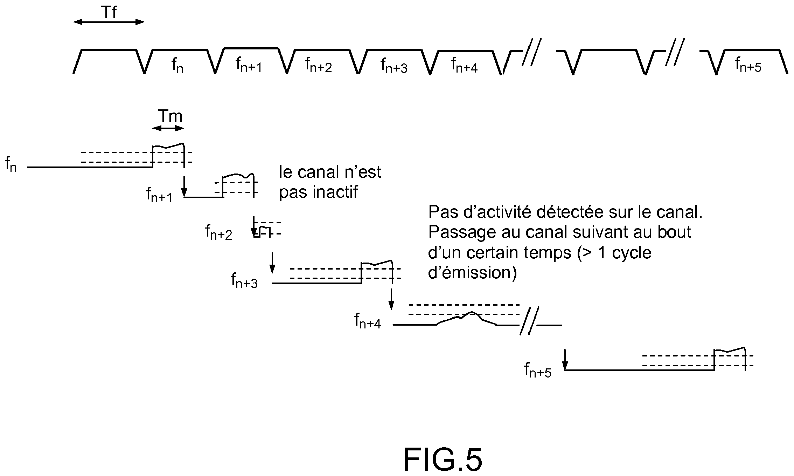

La figure 5 décrit un exemple de réalisation de calibration en vol. Le logiciel embarqué temps réel spécifique selon l'invention est développé sur la machine de traitement cible pour réaliser automatiquement les mesures de calibration. Il exécute le même cylce de veille et sous réserve de détection de l'émission dans des conditions acceptables, il mesure la réponse différentielle du réseau d'antennes sur chaque fréquence. Les résultats de mesure sont transmis pour stockage et exploitation ultérieure, ou posts-traitement au sol en différé.

Le principe de la sycnhronisation mis en oeuvre repose sur la détection d'inactivité puis d'actvité du canal fréquentiel attendu. Dans les bandes de fréquences concernées par l'invention, la puissance moyenne de bruit dans le canal est quasi-constante et ne dépend que des caractéristiques de la chaîne de réception. Il est donc possible de définir deux seuils fixes en niveau permettant de contrôler, d'une part qu'aucun signal fort n'est présent sur le canal, d'autre part, que le rapport signal sur bruit reçu est suffisant pour une mesure, ce qui correspond à :

Canal inactif: niveau <seuil_inactivité
Canal actif pour une mesure : niveau >seuil_activité.

La mesure d'activité est effectuée, par exemple, au rythme Tb de réception des blocs d'échantillons élémentaires, entre 40 et $160\mu$s.

On suppose que l'émetteur émet une nouvelle fréquence tous les Tf ms et que la fréquence est maintenue pendant une durée proche de Tf. La mesure de la réponse du réseau est intégrée sur une durée Tm inférieure à la durée de maintien compte tenu des temps de garde nécessaires à la détection d'inactivité et d'activité.

Le schéma de la figure 5 présente plusieurs cas :

- de synchro générale suite à une rupture : démarrage, niveau insuffisant sur une fréquence attendue,

tarage, synchro sur $f_n$ ou $f_{n+5}$ sur la figure 5 ;

- d'un canal occupé par une émission : ce cas n'est pas souhaitable puisque l'émetteur de calibration risque de brouiller pendant un bref instant cet émetteur d'environnement. Malgré toutes les précautions qui peuvent être prises dans le choix des fréquences de calibration il est préférable que l'algorithme prenne en compte ce cas ; canal $f_{n+2}$ sur la figure 5 ;

- d'un canal de puissance insuffisante (bilan de liaison insuffisant, masquage...); canal $f_{n+4}$ sur la figure 5.

La détection d'activité sur chaque fréquence est effectuée sur chaque bloc reçu par corrélation sur la durée du bloc du signal reçu avec le signal attendu. Pour simplifier les calculs, la fréquence sera choisie multiple de Fe/N et dans la bande utile.

Pour la fréquence en bande de base f=p*Fe/N la corrélation sur un bloc s'exprime comme suit :

$$X(m) = \frac{1}{N} \cdot \sum_{n=0}^{N-1} x(mN+n) \cdot e^{-2.\pi.j.\frac{p.n}{N}}$$

Il s'agit de la sortie d'un filtre en sinus cardinal de largeur Fe/N (25 kHz) qui peut être rendu plus sélectif en appliquant une fenêtre de pondération, par exemple.

Sur le bloc n° m il n'y a pas de signal présent si :

$$|X(m)|^2 < \text{seuil\_inactivite}$$

Sur le bloc n° m un signal de niveau suffisant estprésent si :

$$|X(m)|^2 > \text{seuil\_activite}$$

Une seule voie de réception effectue le test d'activité.

Sur chaque bloc l'inactivité est contrôlée jusqu'à ce que le canal soit actif. Eventuellement, en fonction des caractéristiques de la chaîne d'émission (positionnement du synthétiseur en particulier) on attendra un certain nombre de blocs avant de commencer l'intégration du signal.

Pour que la mesure soit validée, il faut que le canal reste actif sur les P blocs intégrés.

Les mesures sur chaque bloc m et pour chaque voie i de réception sont regroupées et corrigées par la valeur de tarage mesurée préalablement sur cette fréquence :

$$X^i(m) = X^i(m) \cdot \underline{Xcor}^i(f)$$

Sur chaque voie les mesures sont intégrées de façon cohérente sur les P blocs actifs :

$$X^i = \frac{1}{P} \cdot \sum_{p=0}^{P-1} X^i(p)$$

La mesure attendue correspond au vecteur de composantes conj($X^1$).$X^i$ pour i=1..NB_VOIES

## Durée d'un cycle de balayage :

La contrainte est fixée par les considérations suivantes :
Une même fréquence doit être calibrée pour toutes les incidences avec un écart max. de X degrés (typiquement de l'ordre de 1 degré). Un cycle complet de balayage doit pouvoir être exécuté avant que l'incidence ait varié de plus de X degré. La vitesse radiale max. du Porteur permet de fixer cette durée max. du cycle de balayage.

La possibilité d'intégrer le signal reçu sur une fréquence permet de mieux s'affranchir du bruit propre de la chaîne de réception dans le canal de mesure et de gagner sur le bilan de liaison, ou pour un rapport signal sur bruit minimal requis de limiter le niveau de signal nécessaire donc la puissance d'émission.

Cette durée d'intégration cumulée avec le temps de commutation en fréquence de l'émetteur sol de calibration permet de déterminer le nombre de fréquences qui peuvent être calibrées pendant un cycle de balayage.

## Durée d'intégration :

Il faut toutefois considérer les limitations principales liées à la chaîne de réception et de numérisation qui possède une dynamique inévitablement limitée, ce qui signifie la présence potentielle de fréquences parasites dans le canal de mesure.

En supposant que ce plancher corresponde à un niveau max. de -70 dBm en entrée CAN, il ne sert à rien de réduire la bande de bruit en dessous de df tel que :
Niveau de bruit inévitable sur 50 ohms en entrée récepteur (kTO) + facteur de bruit + gain maximal du récepteur + 10*log10(df) < -70 dBm, soit df < 25 à 100 kHz suivant la stratégie de CAG. L'ordre d'intégration P varie donc entre 1 (aucune d'intégration) et 25.

La durée d'intégration maximale Tm est donc de l'ordre de 1 ms max. (chaque bloc élémentaire fait 40 μs).

Le rapport signal à (bruit + plancher parasite) requis pour la calibration est au minimum de 20 dB, ce qui correspond à un signal min. ramené au pied d'antenne de l'ordre de -89 dBm.

Le Porteur se déplaçant, un décalage Doppler peut être observé en réception, la bande du canal de mesure doit donc être supérieure à ce décalage, le décalage maximal est égal à la vitesse radiale maximale de l'avion / longueur d'onde minimale.

La vitesse radiale maximale est d'environ 125m/s, la longueur d'onde minimale est d'environ c/1.6 GHz, soit 0.18 m. Le décalage Doppler maximal est donc de 667 Hz, ce qui reste négligeable compte tenu des éléments vus précédemment.

## Capacité de balayage de l'émetteur :

Le goniomètre doit terminer son intégration, placer le récepteur en attente sur la fréquence suivante, vérifier que le canal attendu est inactif avant que l'émetteur ne devienne actif sur cette fréquence.

De plus, le signal doit être maintenu suffisamment longtemps pour permettre sa détection. En adoptant le principe selon lequel la calibration se fait par sous-gamme réseau couverte par un même amplificateur et une même antenne, il faut prendre en compte les temps de positionnement du synthétiseur d'émission à mieux qu'1 kHz. En pratique, la grande majorité des synthétiseurs programmables tiennent la spécification d'1 ms.

Le mécanisme de synchronisation prévu impose donc une période de balayage de 4 à 5 ms suivant les marges.

Compte tenu des éléments étudiés ci-dessus, pour un scénario de vol à 25 km min. de distance, et pour une vitesse du Porteur maximale (450 km/h), la vitesse angulaire max. est inférieure à 0.3°/s.

La fraîcheur de données de navigation doit garantir une variation sur les angles des directions d'arrivée reçues inférieure à 0.1 à 0.2 degrés, soit pour une vitesse angulaire de 0.3°/s, une fraîcheur de 250 ms à 0.5 s environ en se limitant à un vol non perturbé.

Le mécanisme de synchronisation avec intégration des mesures et temps de ralliement en fréquence de l'émetteur permet donc de « passer » au minimum 600 mesures par cycle de balayage ce qui est largement surdimensionné par rapport au besoin exprimé par les études des paragraphes précédents et rappelés ci-dessous :

- environ 25 points à calibrer sur la sous gamme 30 - 150 MHz,
- environ 50 points à calibrer sur la sous-gamme 150 - 500 MHz,
- environ 100 points à calibrer la sous-gamme 0.88 - 1.65 GHz

La durée des essais de calibration n'est pas déterminée par les temps de mesure à proprement parler, mais d'une part par les difficultés de mise en oeuvre opérationnelle de ces essais (météo, disponibilité des moyens à assurer, analyse des fréquences occupées, mesures à vide à la suite de bilans ponctuellement insuffisants), et d'autre part les temps d'analyse et de post-traitement des tables identifiant des besoins de reprise ou d'affinage en fréquence des mesures,...).

Le système et le procédé selon l'invention offrent notamment comme avantages de minimiser les coûts de calibration ou de recalibration d'antennes.

## EP 2 749 892 B1

Le système et le procédé selon l'invention permettent également pour certaines applications de réaliser des calibrations ou des recalibrations en élévations, ce qui n'était pas possible auparavant.

## Revendications

1. Procédé pour calibrer une antenne fixe (20) comportant plusieurs dipôles (21a, 21b, 21c, 21d, 21e) **caractérisé en ce qu'**il comporte au moins les étapes suivantes :

   • l'utilisation d'un aéronef (50) équipé d'une antenne directive (51) large bande, ledit aéronef effectuant une rotation autour de ladite antenne (20) fixe à calibrer, l'émission d'un signal à partir de l'antenne de l'aéronef dans une plage de fréquences $[F_1, F_2]$ pour lesquelles on cherche à calibrer ladite antenne (20),
   • la mesure du niveau Nsa, Nsb, Nsc, Nsd, Nse de signal reçu par un dipôle et la mesure des différences de phase $\varphi_{a,b}$, $\varphi_{b,c}$, $\varphi_{c,d}$, $\varphi_{d,e}$, $\varphi_{e,b}$, entre chaque dipôle ($21_a$, $21_b$, $21_c$, $21_d$, $21_e$) de l'antenne à calibrer, pour chaque fréquence Fr de la plage de fréquences sélectionnée, au cours d'une rotation de T° de l'aéronef autour de l'antenne à calibrer,
   • la détermination d'une note de qualité du signal reçu par comparaison d'un niveau de signal mesuré à un niveau de signal attendu pour un angle d'émission donné,
   • la mémorisation des valeurs des écarts entre l'angle incident mesuré et l'angle incident théorique pour une valeur de fréquence Fr, dans une table de calibration.

2. Procédé selon la revendication 1 **caractérisé en ce que** l'aéronef est un drone comprenant une composante sol (30) et une composante embarquée (40) qu'il comporte au moins les étapes suivantes :

   3.a) le drone se positionne à un azimut initial situé sur un cercle de rayon R déterminé à partir des coordonnées de l'antenne à calibrer, et transmet les informations de son positionnement et un signal « prêt » à émettre à la composante sol du drone,
   3.b) la composante sol du drone configure la chaîne de réception du de l'antenne à calibrer pour une détection dans une fréquence Fr voulue et transmet un top d'émission au drone (50),
   3.c) l'antenne (51) du drone (50) émet à la fréquence attendue Fr, et communique à la composante sol (30) sa position X datée et la fréquence émise Fe,
   3.d) les dipôles de l'antenne à calibrer reçoivent l'onde émise, et la chaîne de réception de l'antenne mesure la valeur de l'amplitude du signal reçu pour chacun des dipôles, ainsi que les différences de phase entre chaque dipôle,
   3.e) le drone suit toujours la circonférence autour de l'antenne, sans marquer d'arrêt, et transmet tous les x degrés parcourus, une information de positionnement datée et la fréquence émise, et les valeurs mesurées en 3d),
   3.f) en fin de circonférence, le drone émet une information de prêt à émettre et reboucle à l'étape 3.b) en incrémentant la valeur de fréquence de Δf puis exécute les étapes 3.c) 3.d) et 3.e),
   3.g) le procédé est terminé lorsque tous les azimuts ont tous été balayés avec la bande de fréquence complète.

3. Procédé selon la revendication 2 **caractérisé en ce que** le drone effectue une rotation complète autour de l'antenne à calibrer (20).

4. Système pour calibrer une antenne fixe (20) comportant plusieurs dipôles (21a, 21b, 21c, 21d, 21e) comportant au moins les éléments suivants

   • un aéronef (50) équipé d'une antenne directive (51) large bande, ledit aéronef étant adapté à effectuer une rotation autour de ladite antenne (20) fixe à calibrer, à émettre un signal à partir de l'antenne de l'aéronef dans une plage de fréquences $[F_1, F_2]$ pour lesquelles on cherche à calibrer ladite antenne (20),
   • un moyen (31, 35) de mesure du niveau Nsa, Nsb, Nsc, Nsd, Nse de signal reçu par un dipôle et de mesure des différences de phase $\varphi_{a,b}$, entre chaque dipôle ($21_a$, $21_b$, $21_c$, $21_d$, $21_e$) de l'antenne à calibrer, pour chaque fréquence Fr de la plage de fréquences sélectionnée, au cours d'une rotation de T degrés de l'aéronef autour de l'antenne à calibrer,
   • un moyen (31) adapté à déterminer une note de qualité du signal reçu par comparaison d'un niveau de signal mesuré à un niveau de signal attendu pour un angle d'émission donné,
   • un moyen de mémorisation des valeurs des écarts entre l'angle incident mesuré et l'angle incident théorique pour une valeur de fréquence Fr, dans une table de calibration.

## Patentansprüche

1. Verfahren zum Kalibrieren einer festen Antenne (20), welche mehrere Dipole (21a, 21b, 21c, 21d, 21e) beinhaltet, **dadurch gekennzeichnet, dass** es mindestens folgende Schritte beinhaltet:

   • Verwenden eines Luftfahrzeugs (50), welches mit einer Richtantenne (51) mit breitem Band ausgerüstet ist, wobei das Luftfahrzeug eine Rotation um die feste zu kalibrierende Antenne (20) vornimmt, Senden eines Signals von der Antenne des Luftfahrzeugs in einem Bereich von Frequenzen [F1, F2], für welche man die Antenne (20) zu kalibrieren wünscht,

• Messen des Pegels Nsa, Nsb, Nsc, Nsd, Nse des von einem Dipol empfangenen Signals und Messen der Phasendifferenzen $\varphi_{a,b}$, $\varphi b,c$, $\varphi c,d$, $\varphi d,e$, $\varphi e,a$, zwischen einem jeden Dipol (21a, 21b, 21c, 21d, 21e) der zu kalibrierenden Antenne, für jede Frequenz Fr des gewählten Frequenzbereichs, im Zuge einer Rotation um T° des Luftfahrzeugs um die zu kalibrierende Antenne,

• Bestimmen einer Qualitätsnote des empfangenen Signals durch Vergleich eines gemessenen Signalpegels mit einem für einen gegebenen Sendewinkel erwarteten Signalpegel,

• Speichern der Abweichungswerte zwischen dem gemessenen Einfallwinkel und dem theoretischen Einfallwinkel für einen Frequenzwert Fr in einer Kalibriertabelle.

**2.** Verfahren nach Anspruch 1, **dadurch gekennzeichnet, dass** das Luftfahrzeug eine Drohne ist, welche eine Bodenkomponente (30) und eine Bordkomponente (40) beinhaltet und dadurch, dass es mindestens folgende Schritte beinhaltet:

3.a) Die Drohne positioniert sich an einem Anfangsazimut, welches sich auf einem Kreis mit Radius R befindet, welcher anhand der Koordinaten der zu kalibrierenden Antenne bestimmt wird, und überträgt die Daten ihrer Positionierung und ein "Bereit-Signal", welches an die Bodenkomponente der Drohne gesendet werden soll,

3.b) Die Bodenkomponente der Drohne konfiguriert die Empfangskette der zu kalibrierenden Antenne für eine Erkennung in einer gewünschten Frequenz Fr und überträgt ein Sendesignal an die Drohne (50),

3.c) Die Antenne (51) der Drohne (50) sendet in der erwarteten Frequenz Fr und kommuniziert der Bodenkomponente (30) ihre Position X mit Datum und die gesendete Frequenz Fe,

3.d) Die Dipole der zu kalibrierenden Antenne empfangen die gesendete Welle, und die Empfangskette der Antenne misst den Amplitudenwert des empfangenen Signals für jeden der Dipole sowie die Phasendifferenzen zwischen einem jeden Dipol,

3.e) Die Drohne folgt noch immer dem Kreisumfang rund um die Antenne, ohne zu stoppen, und überträgt jeweils alle x zurückgelegten Grade eine Positionierungsinformation mit Datum und die gesendete Frequenz, und die im Schritt

3.d) gemessenen Werte,

3.f) Bei Ende des Kreisumfangs sendet die Drohne eine Information "Sendebereit" und nimmt die Schleife bei Schritt 3.b) wieder auf durch Erhöhen des Frequenzwertes um $\Delta f$ und führt danach die Schritte 3.c) 3.d) und 3.e) aus,

3.g) Das Verfahren ist beendet, wenn alle Azimute mit dem vollständigen Frequenzband abgetastet wurden.

**3.** Verfahren nach Anspruch 2, **dadurch gekennzeichnet, dass** die Drohne eine komplette Rotation rund um die zu kalibrierende Antenne (20) vornimmt.

**4.** System zum Kalibrieren einer festen Antenne (20), welche mehrere Dipole (21a, 21b, 21c, 21d, 21e) beinhaltet, **dadurch gekennzeichnet, dass** es mindestens folgende Elemente beinhaltet:

• ein Luftfahrzeug (50), welches mit einer Richtantenne (51) mit breitem Band ausgerüstet ist, wobei das Luftfahrzeug geeignet ist, eine Rotation um die feste zu kalibrierende Antenne (20) vorzunehmen und ein Signal von der Antenne des Luftfahrzeugs in einem Bereich von Frequenzen [F1, F2], für welche man die Antenne (20) zu kalibrieren wünscht, zu senden,

• ein Mittel (31, 35) zum Messen des Pegels Nsa, Nsb, Nsc, Nsd, Nse des von einem Dipol empfangenen Signals und zum Messen der Phasendifferenzen $\varphi_{a,b}$, $\varphi b,c$, $\varphi c,d$, $\varphi d,e$, $\varphi e,a$, zwischen einem jeden Dipol (21a, 21b, 21c, 21d, 21e) der zu kalibrierenden Antenne, für jede Frequenz Fr des gewählten Frequenzbereichs, im Zuge einer Rotation um T Grad des Luftfahrzeugs um die zu kalibrierende Antenne,

• ein Mittel (31), welches geeignet ist, eine Qualitätsnote des empfangenen Signals durch Vergleich eines gemessenen Signalpegels mit einem für einen gegebenen Sendewinkel erwarteten Signalpegel zu bestimmen,

• ein Mittel zum Speichern der Abweichungswerte zwischen dem gemessenen Einfallwinkel und dem theoretischen Einfallwinkel für einen Frequenzwert Fr in einer Kalibriertabelle.

**Claims**

**1.** Method for calibrating a fixed antenna (20) comprising a plurality of dipoles (21a, 21b, 21c, 21d, 21e) **characterised in that** it comprises at least the following steps:

• using an aircraft (50) which is provided with a broadband directional antenna (51), the aircraft carrying out a rotation about the fixed antenna (20) which is intended to be calibrated, transmitting a signal from the antenna of the aircraft in a frequency range [F1, F$_2$] for which it is desirable to calibrate the antenna (20),

• measuring the level Nsa, Nsb, Nsc, Nsd, Nse of the signal received by a dipole and measuring the phase differences cpa,b, $\varphi_{b,c}$, $\varphi_{c,d}$, $\varphi_{d,e}$ $\varphi_{e,a}$ between each dipole ($21_a$, $21_b$, $21_c$, $21_d$, $21_e$) of the antenna to be calibrated, for each frequency Fr of the frequency range selected, during a rotation of T° of the aircraft about the antenna to be calibrated,

• determining a quality rating of the signal received by comparing a signal level measured to an anticipated signal level for a specific transmission angle,

• storing the values of the deviations between the incident angle measured and the theoretical incident angle for a frequency value Fr, in a calibration table.

2. Method according to claim 1, **characterised in that** the aircraft is a drone which comprises a ground component (30) and an on-board component (40) and **in that** it comprises at least the following steps:

3.a) the drone is positioned at an initial azimuth located on a circle having a radius R determined from the coordinates of the antenna to be calibrated, and transmits the information relating to its positioning and a "ready" signal to be transmitted to the ground component of the drone.

3.b) the ground component of the drone configures the reception channel of the antenna to be calibrated for detection at a desired frequency Fr and transmits a transmission signal to the drone (50),

3.c) the antenna (51) of the drone (50) transmits at the anticipated frequency Fr, and communicates to the ground component (30) the dated position X thereof and the frequency transmitted Fe,

3.d) the dipoles of the antenna to be calibrated receive the transmitted wave, and the reception channel of the antenna measures the value of the amplitude of the signal received for each of the dipoles, and the phase differences between each dipole,

3.e) the drone always follows the circumference around the antenna, without stopping, and transmits, for every x degrees travelled, dated positioning information and the frequency transmitted, and the values measured at 3d),

3.f) at the end of the circumference, the drone transmits transmission readiness information and takes up the loop again at step 3.b) while incrementing the frequency value by Δf then carries out the steps 3.c), 3.d) and 3.e),

3.g) the method is terminated when all the azimuths have all been scanned with the complete frequency band.

3. Method according to claim 2, **characterised in that** the drone carries out a complete rotation about the antenna (20) to be calibrated.

4. System for calibrating a fixed antenna (20) comprising a plurality of dipoles (21a, 21b, 21c, 21d, 21e) comprising at least the following elements

• an aircraft (50) which is equipped with a broadband directional antenna (51), the aircraft being capable of carrying out a rotation about the fixed antenna (20) to be calibrated, transmitting a signal from the antenna of the aircraft in a frequency range [F$_1$, F$_2$] for which it is desirable to calibrate the antenna (20),

• a means (31, 35) for measuring the level Nsa, Nsb, Nsc, Nsd, Nse of the signal received by a dipole and measuring the phase differences $\varphi_{a,b}$, $\varphi_{b,c}$, $\varphi_{c,d}$, $\varphi_{d,e}$, $\varphi_{e,a}$ between each dipole ($21_a$, $21_b$, $21_c$, $21_d$, $21_e$) of the antenna to be calibrated, for each frequency Fr of the frequency range selected, during a rotation of T degrees of the aircraft about the antenna to be calibrated,

• a means (31) which is capable of determining a quality rating of the signal received by comparing a signal level measured to an anticipated signal level for a specific transmission angle,

• a means for storing the values of the deviations between the incident angle measured and the theoretical incident angle for a frequency value Fr, in a calibration table.

CALIBRATION EN POLARISATION VERTICALE

Dipôles Verticaux du réseau

$K(\theta_i, \Delta_i)$

$(\Delta_i)$

$(\theta_i)$

Emetteur en champ lointain

Antenne d'émission en polarisation verticale : dipôles verticaux

FIG.1

EP 2 749 892 B1

FIG.2

EP 2 749 892 B1

3.a — positionnement drone

3.b — config. chaîne réception top émission

3.c — émission d'une onde

3.d — acquisition des données mémorisation des résultats

3.e — rotation du drone

3.f — test — non

3.g — configuration fréquence varie incrément ΔF

3.h — config. chaine de réception

3.i — non

fin

FIG.3

4.a — positionnement drone config chaine émission

4.b — config chaine réception

4.c — émission à une fréquence Fr

4.d — mesure et mémorisation des résultats

4.e — variation fréquence Fr avec pas ΔFr

4.f — test — non

4.g — nouveau positionnement drone

4.h — config. chaine de réception F initiale

4.i — non

fin

FIG.4

Tf

$f_n$ $f_{n+1}$ $f_{n+2}$ $f_{n+3}$ $f_{n+4}$ $f_{n+5}$

Tm

$f_n$

$f_{n+1}$

le canal n'est pas inactif

$f_{n+2}$

Pas d'activité détectée sur le canal. Passage au canal suivant au bout d'un certain temps (> 1 cycle d'émission)

$f_{n+3}$

$f_{n+4}$

$f_{n+5}$

FIG.5

EP 2 749 892 B1

**EP 2 749 892 B1**

## RÉFÉRENCES CITÉES DANS LA DESCRIPTION

**Documents brevets cités dans la description**

- JP H05302947 B